(19) Europäisches Patentamt
European Patent Office
Office européen des brevets

(11) EP 3 688 823 B1

(12) EUROPEAN PATENT SPECIFICATION

(45) Date of publication and mention
of the grant of the patent:
16.06.2021 Bulletin 2021/24

(51) Int Cl.:
H01L 41/18 (2006.01)

(21) Application number: 18772815.9

(22) Date of filing: 26.09.2018

(86) International application number:
PCT/EP2018/076039

(87) International publication number:
WO 2019/063577 (04.04.2019 Gazette 2019/14)

(54) **ACTUATOR MEMBER AND METHOD FOR FORMING THE SAME**

AKTUATORELEMENT UND VERFAHREN ZUR HERSTELLUNG DAVON

MEMBRE D'ACTIONNEUR ET SON PROCÉDÉ DE FABRICATION

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR

(30) Priority: 29.09.2017 EP 17193985

(43) Date of publication of application:
05.08.2020 Bulletin 2020/32

(73) Proprietor: Koninklijke Philips N.V.
5656 AG Eindhoven (NL)

(72) Inventors:
• PELSSERS, Eduard Gerard Marie
5656 AE Eindhoven (NL)
• VAN DEN ENDE, Daan Anton
5656 AE Eindhoven (NL)
• HAKKENS, Franciscus Johannes Gerardus
5656 AE Eindhoven (NL)
• HILGERS, Achim
5656 AE Eindhoven (NL)
• JOHNSON, Mark Thomas
5656 AE Eindhoven (NL)

(74) Representative: Philips Intellectual Property &
Standards
High Tech Campus 5
5656 AE Eindhoven (NL)

(56) References cited:
GB-A- 2 243 946          US-A1- 2013 253 146
US-A1- 2014 004 364

**Description**

FIELD OF THE INVENTION

This invention relates to an actuator member and method for forming the same, and in particular to an actuator member comprising an electroactive polymer.

BACKGROUND OF THE INVENTION

US2014004364 discloses a dielectric film that includes an elastomer and barium titanate particles with a crystallinity of 80% or more. A transducer includes the dielectric film and a plurality of electrodes with the dielectric film interposed therebetween. The transducer is excellent in resistance to dielectric breakdown and can output a large force.
Electroactive materials (EAMs) are a class of materials within the field of electrically responsive materials. When implemented in an actuation device, subjecting an EAM to an electrical drive signal can make it change in size and/or shape. This effect can be used for actuation and sensing purposes. There exist inorganic and organic EAMs. One particular kind of organic EAM is that of electroactive polymers (EAPs).
Electroactive polymers (EAPs) are an emerging class of materials within the field of electrically responsive materials. EAPs can work as sensors or actuators and can easily be manufactured into various shapes allowing easy integration into a large variety of systems.
Materials have been developed with characteristics such as actuation stress and strain which have improved significantly over the last ten years. Technology risks have been reduced to acceptable levels for product development so that EAPs are commercially and technically becoming of increasing interest. Advantages of EAPs include low power, small form factor, flexibility, noiseless operation, accuracy, the possibility of high resolution, fast response times, and cyclic actuation.
The improved performance and particular advantages of EAP material give rise to applicability to new applications.
An EAP device can be used in any application in which a small amount of movement of a component or feature is desired, based on electric actuation. Similarly, the technology can be used for sensing small movements.
The use of EAPs enables functions which were not possible before, or offers a big advantage over common sensor / actuator solutions, due to the combination of a relatively large deformation and force in a small volume or thin form factor, compared to common actuators. EAPs also give noiseless operation, accurate electronic control, fast response, and a large range of possible actuation frequencies, such as 0 - 1 MHz, most typically below 20 kHz.
For a number of applications, local control of a surface shape is highly desirable, for instance to enhance efficiency of surface contact (e.g. for on-body sensing or imaging devices), or to provide additional functionality (e.g. friction control, massage, cleaning, microfluidics). In both cases, flexibility in surface change is required. In some cases, layers or continuous bodies of electroactive material, e.g. EAP, are used as actuators. However, such solutions limit the degree of control that can be achieved in manipulating surface shape. Local surface profile variation is difficult with a single continuous body of EAP.
By way of alternative, it has previously been suggested to provide an actuator comprising EAM particles or elements dispersed in a compliant matrix. By for instance stimulating different regions of the embedded particles, either through applying a non-homogenous field or through embedding the particles in the matrix with a non-homogenous density distribution, localized shape change and surface topology change of the actuator can be achieved.
Activation of the EAM particles in the matrix material can be achieved using electrodes applied to the compliant material. Use of embedded particles rather than a continuous body of EAM enhances controllability of the shape of the actuator member, and in particular enables fine-grained control of topology of surface profile.
However, the efficiency of electrical transfer between the electrodes of such an actuator and the dispersed EAM particles can often be non-ideal. This is because electrical fields or currents applied to the actuator member must propagate through the entire composite body, which includes a large amount of matrix material. Much of the applied electrical power is drained across the intermediate matrix material. This results in reduced power supply to the EAM material elements and hence reduced actuation force of the actuator.

SUMMARY OF THE INVENTION

An actuator comprising EAP particles embedded in a compliant matrix is desired wherein improved electrical supply is provided to the EAP particles.
It has been realized by the inventors of the present invention that the inefficiency of electrical transfer arises primary due to disparity in electrical properties of the EAP particles and the matrix material. In particular, typically the matrix material within which the particles are embedded has a much higher resistance than the EAP material, e.g.

between 1000 and 10000 times higher. As a result, the electrical losses across the matrix material (as opposed to the EAP material) dominate, and the resultant voltage across the EAP particles is much reduced.

The invention provides a solution to mitigate this problem. The invention is defined by the independent claims. The dependent claims define advantageous embodiments.

According to an aspect of the invention, there is provided an actuator member comprising a body of composite material having a first major surface and a second major surface, the composite material comprising electroactive polymer particles distributed in a compliant matrix material, and wherein the composite material of the body comprises one or more continuous material paths extending from the first major surface to the second major surface, each encompassing at least one electroactive polymer particle, and wherein all material forming each of the paths has an electrical resistivity equal to or less than an electrical resistivity of the electroactive polymer particles.

The invention is based on providing an actuator member formed of a composite material of EAP particles distributed in a matrix, and wherein a material structure of the body is such that there are continuous material paths extending between major surfaces which include material all of which has electrical resistivity either equal to or less than that of the EAP particles encompassed or intersected by those paths.

This ensures that there exist low impedance electrical paths connecting EAP particles of the structure and major surfaces, allowing efficient electrical supply to the EAP particles from for instance electrodes applied to the major surfaces. In this way, the problem of significant electrical drop or dissipation across interposing matrix material is substantially avoided, and efficient electrical transfer facilitated. Preferably a large number of such material paths exist to allow a large proportion of the EAP particles to be thus efficiently electrically supplied.

For the avoidance of doubt, by electrical resistivity is meant the standard physical property by that name having units of Ohm meters ($\Omega$m), and defined as the resistance of a specimen of material multiplied by a cross sectional area of the specimen, divided by a length of the specimen extending outwardly or perpendicularly to the cross-sectional area. Equivalently, the resistance exhibited across a specimen is given by the resistivity, multiplied by the specimen's length, and divided by its cross-sectional area.

By electroactive polymer particles is meant small pieces of electroactive polymer. These may be in any form, for instance granules, grains, rods or any other form of particle. The electroactive polymer particles may in accordance with at least some embodiments have a largest dimension (e.g. width, height, diameter) of no more than 100 micrometers.

The purpose of using EAP particles is to enable locally variable deformation of the actuator member, facilitating complex shape and topology changes through for instance application of inhomogeneous electrical fields.

The composite material of said body may comprise a plurality of said continuous material paths.

The electrical resistivity of all material forming each of the continuous material paths may be less than or equal to $1 \times 10^{13}$ $\Omega$m. The aim of the invention is to improve electrical supply to the dispersed EAP particles via the continuous material paths. A generally low absolute resistivity is therefore beneficial. It has been found that a resistivity at or below $1 \times 10^{13}$ $\Omega$m for all material forming the one or more continuous material paths provides for a particularly good level of electrical leakage around the EAP particles, facilitating particularly strong and reliable shape change deformation performance.

As noted above, EAPs provide unique benefits in terms of actuation performance. In particular, they provide a combination of relatively large deformation and force in a small volume or thin form factor, compared to common actuators. EAPs also give noiseless operation, accurate electronic control, fast response, and a large range of possible actuation frequencies, such as 0 - 1 MHz.

In accordance with one or more embodiments, all material forming each of said continuous material paths may further have a relative permittivity equal to or greater than a relative permittivity of the electroactive polymer particles. The relative permittivity (or dielectric constant) of a material is related to the electrical impedance the material exhibits. In particular, the greater the relative permittivity of a material, the greater is the capacitance exhibited by a body comprising the material, and hence the lower the impedance of that body.

Hence by ensuring, in accordance with these embodiments, also that material forming each path has a relative permittivity not less than that of the EAP of the EAP particles, it is further ensured that low impedance electrical paths exist across the composite body to efficiently electrically supply the EAP particles.

In preferred cases, the relative permittivity of all of the material forming each path may be substantially equal to that of the EAP. This avoids that there is inhomogeneity in resultant electrical field strength across the composite body, which could lead to locally high field strengths in certain areas and in certain cases this may lower the electrical breakdown voltage, which may in extreme cases have the consequence that the maximum operating voltage of the actuator member is decreased.

By substantially equal may for instance mean that the relative permittivity of the matrix is at least within 15% of that of the EAP, or at least within 10%, or at least within 5%, or at least between 0% and 5%.

In accordance with one set of embodiments, one or more of the material paths may be a continuous path of electroactive polymer, formed by a continuous chain of electroactive polymer particles extending from the first major surface to the second major surface. Here, the composite material of the actuator member effectively comprises veins of EAP material extending through the composite from the first to the second major surface. The chain of EAP particles are arranged such that they effectively connect in electrical series, providing efficient electrical supply across all of them.

There are different ways of providing a material structure which includes such continuous paths of EAP particles. One means is simply to form the composite material having a sufficiently high volume fraction of EAP material to matrix material that such paths spontaneously form when fabricating the actuator member.

In at least one set of embodiments, the composite material comprises at least 20% by volume of electroactive polymer particles, and preferably comprises at least 50% by volume of electroactive polymer particles, and even more preferably comprises at least 70% by volume of electroactive polymer particles.

By this is meant that as a proportion of the total volume of the body of composite material, at least 25% or, preferably, at least 50%, or more preferably at least 70% is constituted by the aggregate volume of the EAP particles.

The required volume fraction of EAP particles in order that the EAP material paths form may depend upon the particular size and shape of the EAP particles used. It has been found that volume fractions as low as 25% may be sufficient to provide spontaneously forming EAP material paths. However, higher volume fractions may typically be preferred since the probability of EAP material paths forming increases with higher volume fraction of EAP. Hence, reliable formation of the material paths may be better ensured through provision of at least 50% of EAP particles or more preferably at least 70% of EAP particles.

The actuator member may be heated after fabrication and curing of the compliant matrix so as to anneal the EAP particles. The EAP particles are in this way effectively fused with one another. This ensures strong and robust contact between connecting EAP particles of the chain, and therefore reliable supply of electrical power to all EAP particles of the path.

There is thus provided in these embodiments an actuator member wherein the composite material of the body comprises one or more materially continuous paths of EAP material extending from the first major surface to the second major surface, each path formed of a continuous chain of materially fused EAP particles.

Additionally or alternatively, at least portions of the matrix material may be provided having electrical properties which are sufficiently low in impedance to avoid the problem of poor electrical supply to the EAP particles. In this way material paths may be formed incorporating both EAP particles and said portions of matrix material, and efficient electrical supply facilitated.

Hence in accordance with these embodiments, one or more of the material paths may be a composite path formed of at least one electroactive polymer particle and connecting matrix material, said connecting matrix material having an electrical resistivity equal to or less than the electrical resistivity of the electroactive polymer particles.

In preferred embodiments, the connecting matrix material may have an electrical resistivity which is less than that of the EAP material forming the EAP particles. In this way, the impedance imposed by the matrix material across the actuator member may be even further decreased, and electrical supply to the EAP material further improved.

In accordance with one or more embodiments, the compliant matrix material may have an electrical resistivity equal to or less than that of the electroactive polymer particles. In this case, the totality of the matrix material of the composite material body is provided having an electrical resistivity equal to or lower than that of the electroactive polymer. This ensures that all material connecting or interposing electroactive polymer particles has sufficiently low electrical resistivity to facilitate efficient electrical supply to the EAP particles. In these cases, the whole body of the actuator member effectively forms a single combined electrical path between the first and second major surfaces.

In preferred embodiments, the compliant matrix material may exhibit an electrical resistivity less than that of the EAP material of the EAP particles. This will result in even further improved electrical supply to EAP particles, as the voltage drop incurred across the matrix material is reduced.

In accordance with one or more embodiments, the compliant matrix material may comprise conductive particles for reducing an electrical resistivity of the matrix material.

Since electrical resistances across the EAP and matrix material are generally relatively high, this reduction in the resistivity of the matrix material may be achieved without consequently causing significant increases in joule heating and other undesirable temperature increases of the actuator.

As noted above, in accordance with one or more embodiments, the relative permittivity (dielectric constant) of the matrix material may be equal to or greater than that of the electroactive polymer. For an ideal parallel plate capacitor, the relative permittivity, $\varepsilon_r$, of the capacitor is related to the capacitance, C, by the expression:

$$\varepsilon_r = \frac{dC}{\varepsilon_0 A}$$

where d is the distance between the plates and A is the area of the plates.

It can hence be seen, modeling portions of the matrix material as a parallel plate capacitor, that adjusting the relative permittivity has a correlated effect upon an exhibited capacitance of a body or element comprised of the material.

This hence provides a parameter for tuning of an exhibited impedance of the matrix material. By adjusting the relative permittivity to be equal to or greater than the relative permittivity of the EAP material, exhibited impedance may be reduced relative to that of the EAP material, therefore increasing the voltage supply to the EAP particles. Actuation power and performance of the EAP material and the actuator member as a whole will consequently be increased.

In certain advantageous embodiments, the compliant matrix material may have a resistivity between 1 and 100 times lower than that of the electroactive polymer of the electroactive polymer particles and preferably between 10 and 100 times lower than that of the electroactive polymer particles.

A further aspect of the invention provides an actuator device comprising: an actuator member as claimed in any preceding claim; and an electrode arrangement disposed around said first and second major surfaces for electrically stimulating the actuator member. The electrode arrangement may include at least one pair of electrodes, a first of the pair disposed on the first major surface of the body and the second of the pair disposed on the second major surface of the body.

The actuator device may further comprise a controller arranged to control provision of electrical stimulation to said actuator member via said electrode arrangement.

A further aspect of the invention provides a method of forming an actuator member comprising: surrounding a plurality of electroactive polymer particles with a compliant matrix material such as to form a body of composite material having a first and second major surface, the body being such as to define one or more continuous material paths extending from the first major surface to the second major surface, each encompassing at least one electroactive polymer particle, and wherein all material forming each of the paths has an electrical resistivity equal to or less than an electrical resistivity of the EAP particles; and curing the matrix material.

In accordance with one or more embodiments, the method may further comprise heating the body of composite material after curing of the matrix material so as to anneal the electroactive polymer particles. This is advantageous particularly in cases where a sufficiently high proportion by volume of EAP particles is included in the composite material to enable spontaneous formation of continuous paths of EAP material through the actuator member body between the first and second major surface, where these are formed by continuous chains of EAP particles. The annealing fuses the adjacent EAP particles of each chain together, such that materially continuous veins of EAP material are provided extending between the major surfaces.

The annealing ensures strong and robust contact between the elements in each path in this case, and therefore ensures that even after many bending actions of the actuator, the paths remain intact.

Forming the actuator member body may be done in a number of different ways.

In accordance with one or more embodiments, said surrounding of the EAP particles may comprise dispersing electroactive polymer particles within a compliant matrix material. The dispersing may comprise mixing of the EAP particles with the matrix material. The dispersing may include pouring of the matrix material onto or with the EAP particles.

In accordance with further embodiments, said surrounding may comprise alternately printing portions or layers of electroactive polymer and compliant matrix material onto a substrate. By this is meant that the EAP and compliant material are alternately printed, for instance in layers or in sections, or in elements or in portions onto a substrate. The substrate may be an electrode for electrically stimulating the actuator member. An opposing electrode may then be disposed on top of the fully formed body to thereby provide an actuator device. By thus alternately printing volumes of EAP material and matrix material, a composite material body may be formed comprising EAP particles dispersed in a compliant matrix.

In accordance with one or more embodiments, the body may be formed with at least 25% by volume of electroactive polymer particles, and preferably at least 50% by volume of electroactive polymer particles, and more preferably at least 70% by volume of electroactive polymer particles. For instance, 25% by volume of electroactive polymer particles may be added to 75% by volume of matrix material, or 50% by volume of electroactive polymer particles may be added to 50% by volume of matrix material, or 70% by volume of electroactive polymer particles added to 30% by volume of compliant material. This ensures that there is sufficient EAP material included in the composite material that continuous paths of EAP material spontaneously form extending between a first major surface and second major surface of the actuator member body. These paths provide effective electrical supply to all EAP particles comprised in the paths.

As noted above, the required volume fraction of EAP particles in order that the EAP material paths form may depend upon the particular size and shape of the EAP particles used. The factors discussed above apply also in relation to this embodiment of the method.

BRIEF DESCRIPTION OF THE DRAWINGS

Embodiments of the invention will now be described in detail with reference to the accompanying drawings, in which:

Figs. 1 and 2 show two possible operating modes for an EAP device;

Fig. 3 illustrates two illustrative extreme states of an actuator member material structure;
Fig. 4 schematically illustrates two material elements in terms of representative electrical circuits;
Fig. 5 illustrates typical voltage over an electroactive polymer particle as a function of time;
Fig. 6 schematically illustrates actuator members comprising different volume fractions of electroactive polymer particles; and
Fig. 7 schematically depicts an actuator member formed by alternate printing of electroactive polymer and matrix material.

DETAILED DESCRIPTION OF THE EMBODIMENTS

The invention provides an actuator member having a body formed of a composite material of electroactive polymer (EAP) elements and compliant matrix material. The composite material of the body is materially structured such that it incorporates one or more continuous material paths extending from a first to a second major surface of the actuator body, each path including at least one EAP particle, and wherein all material of the path has an electrical resistivity equal to or less than that of the EAP particle(s).

As noted above, EAPs can work as sensors or actuators and can easily be manufactured into various shapes allowing easy integration into a large variety of systems.

Devices using electroactive polymers can be subdivided into field-driven and ionic-driven materials.

Examples of field-driven EAPs include Piezoelectric polymers, Electrostrictive polymers (such as PVDF based relaxor polymers) and Dielectric Elastomers. Other examples include Electrostrictive Graft polymers, Electrostrictive paper, Electrets, Electroviscoelastic Elastomers and Liquid Crystal Elastomers.

Examples of ionic-driven EAPs are conjugated/conducting polymers, Ionic Polymer Metal Composites (IPMC) and carbon nanotubes (CNTs). Other examples include ionic polymer gels.

Field-driven EAPs are actuated by an electric field through direct electromechanical coupling. They usually require high fields (volts per meter) but low currents. Polymer layers are usually thin to keep the driving voltage as low as possible.

Ionic EAPs are activated by an electrically induced transport of ions and/or solvent. They usually require low voltages but high currents. They require a liquid/gel electrolyte medium (although some material systems can also operate using solid electrolytes).

Both classes of EAP have multiple family members, each having their own advantages and disadvantages.

A first notable subclass of field-driven EAPs are Piezoelectric and Electrostrictive polymers. While the electromechanical performance of traditional piezoelectric polymers is limited, a breakthrough in improving this performance has led to PVDF relaxor polymers, which show spontaneous electric polarization (field-driven alignment). These materials can be pre-strained for improved performance in the strained direction (pre-strain leads to better molecular alignment). Normally, metal electrodes are used since strains usually are in the moderate regime (1-5%). Other types of electrodes (such as conducting polymers, carbon black based oils, gels or elastomers, etc.) can also be used. The electrodes can be continuous, or segmented.

Another subclass of interest of field-driven EAPs is that of Dielectric Elastomers. A thin film of this material may be sandwiched between compliant electrodes, forming a parallel plate capacitor. In the case of dielectric elastomers, the Maxwell stress induced by the applied electric field results in a stress on the film, causing it to contract in thickness and expand in area. Strain performance is typically enlarged by pre-straining the elastomer (requiring a frame to hold the pre-strain). Strains can be considerable (10-300%). This also constrains the type of electrodes that can be used: for low and moderate strains, metal electrodes and conducting polymer electrodes can be considered, for the high-strain regime, carbon black based oils, gels or elastomers are typically used. The electrodes can be continuous, or segmented.

In some cases, thin film electrodes are added when the polymer itself lacks sufficient conductivity (dimension-wise). The electrolyte can be a liquid, a gel or a solid material (i.e. complex of high molecular weight polymers and metal salts). Most common conjugated polymers are polypyrrole (PPy), Polyaniline (PANi) and polythiophene (PTh).

An actuator may also be formed of carbon nanotubes (CNTs), suspended in an electrolyte. The electrolyte forms a double layer with the nanotubes, allowing injection of charges. This double-layer charge injection is considered as the primary mechanism in CNT actuators. The CNT acts as an electrode capacitor with charge injected into the CNT, which is then balanced by an electrical double-layer formed by movement of electrolytes to the CNT surface. Altering the charge on the carbon atoms results in a change of C-C bond length. As a result, expansion and contraction of single CNT can be observed.

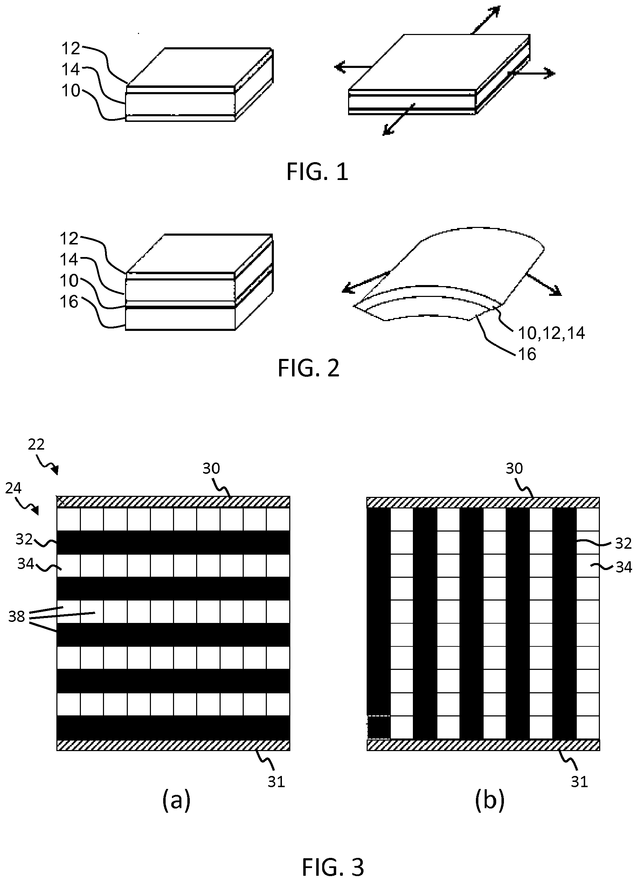

Figs. 1 and 2 show two possible operating modes for an EAP device.

The device comprises an electroactive polymer layer 14 sandwiched between electrodes 10, 12 on opposite sides of the electroactive polymer layer 14.

Fig. 1 shows a device which is not clamped. A voltage is used to cause the electroactive polymer layer to expand in all directions as shown.

Fig. 2 shows a device which is designed so that the expansion arises only in one direction. The device is supported by a carrier layer 16. A voltage is used to cause the electroactive polymer layer to curve or bow.

Together, the electrodes, electroactive polymer layer, and carrier may be considered to constitute the overall electroactive polymer structure.

The nature of this movement may arise from the interaction between the active layer, which expands when actuated, and the passive carrier layer. To obtain the asymmetric curving around an axis as shown, molecular orientation (film stretching) may be applied, forcing the movement in one direction.

The expansion in one direction may result from the asymmetry in the EAP polymer, or it may result from asymmetry in the properties of the carrier layer, or a combination of both.

An electroactive polymer structure as described above may be used both for actuation and for sensing. The most prominent sensing mechanisms are based on force measurements and strain detection. Dielectric elastomers, for example, can be easily stretched by an external force. By putting a low voltage on the sensor, the strain can be measured as a function of voltage (the voltage is a function of the area).

Another way of sensing with field-driven systems is measuring the capacitance-change directly or measuring changes in electrode resistance as a function of strain.

Piezoelectric and electrostrictive polymer sensors can generate an electric charge in response to applied mechanical stress (given that the amount of crystallinity is high enough to generate a detectable charge). Conjugated polymers can make use of the piezo-ionic effect (mechanical stress leads to exertion of ions). CNTs experience a change of charge on the CNT surface when exposed to stress, which can be measured. It has also been shown that the resistance of CNTs change when in contact with gaseous molecules (e.g. $O_2$, $NO_2$), making CNTs usable as gas detectors.

The invention is based on provision of an electroactive polymer based actuator member formed of a composite of EAP particles or elements and a compliant material matrix, where in the member is materially adapted to provide improved electrical supply to EAP particles from electrodes disposed on major surfaces of the member.

Two main approaches are proposed. In a first, there are provided continuous chains of, optionally fused, EAP particles extending through the composite material between the major surfaces, thereby providing effective electrical connection across the entire chain. In a second approach, electrical resistivity of the matrix material is selected such as to be equal to or less than that of the electroactive polymer.

The two approaches are unified in that both provide an actuator member structure comprising one or more continuous material paths extending between major surfaces of the actuator member, which paths include at least one EAP particle and comprise material all of which has an electrical resistivity equal to or less than that of the EAP particles.

To understand either of these two approaches, electrical behavior of the actuator member must be considered. This will now be discussed.

Efficacy of actuation of depends strongly upon the relative electrical properties of the compliant matrix material and the electroactive polymer.

This may be understood by considering the composite material in terms of an equivalent representative circuit of EAP particles and compliant material elements. Each of these elements can itself in turn be regarded as a sub-circuit formed of resistors and capacitors. Each element may in particular be represented as an RC circuit wherein the voltage distribution over the element is, during an initial time period, determined mainly by the charging of the capacitors, and, at later times, progressively determined by resistances of the elements.

Often, very common compliant materials, such as rubbers, have lower relative permittivities, and substantially higher resistances, than electroactive polymers. The result is that in a composite formed of both of these materials the majority of the applied potential difference across the actuator member is drained across the rubber elements and not over the EAP particles, decreasing the efficacy of actuation.

Moreover, differences in relative permittivities between the matrix material (e.g. rubber) and the EAP material elements means that the internal electrical field in the composite material will be inhomogeneous, leading to locally high field strengths. Such high field strengths can in certain cases lower the electrical breakdown voltage in the areas that they cover, with the consequence that the maximum voltage at which the actuator can be operated is decreased.

To demonstrate the problem in more detail, Fig. 3 schematically illustrates two extreme cases for the material structure of an example actuator member 22 comprising a body 24 and having electrodes disposed on a first 30 and second 31 major surface of the body. The body is formed of a composite material. For illustration, the composite material is modeled as being formed of an array of (approximately cubic) material elements 38, some elements formed of electroactive polymer 32, some elements consisting of compliant matrix material 34.

In accordance with the example structure shown in Fig. 3(a), the EAP particles 32 and compliant matrix material elements 34 are formed in alternate parallel rows. Accordingly, each EAP particle is electrically separated from at least one of the major surfaces 30, 31 by at least one row of compliant matrix material. This means that upon application of an electric field across the actuator member 22, the field must penetrate across one or more layers of matrix material before and/or after reaching each electroactive polymer particle 32. This means that the applied electrical field necessarily encounters electrical losses across the compliant matrix material in supplying the electroactive polymer.

This is contrasted with the structural arrangement of Fig. 3(b) which shows an actuator member having a body formed of composite material wherein electroactive polymer particles 32 and compliant matrix material elements 34 are arranged in alternate columns extending between the two electrodes of the two major surfaces 30, 31. Hence, in this arrangement it can be immediately seen that upon application of an electrical field via the electrodes 30, 31, the field is able to penetrate through all of the EAP particles of a given column without ever crossing a compliant matrix material element. This means that the field need not suffer electrical losses across the matrix material in supplying the electroactive polymer. In this arrangement, there are thus provided continuous paths of electroactive polymer extending between the two major surfaces 30, 31. Electrical supply to the EAP in this case is much more efficient.

The arrangement of Fig. 3(b) may be dubbed 'full percolation' of EAP particles, since the EAP particles effectively provide a full EAP material 'percolation' between the two electrodes 30, 31 of the two major surfaces. The arrangement of Fig. 3(a) may be dubbed zero-percolation, since there is no continuous percolation of EAP material from one major surface 30 to the other 31.

Using standard electrical principles, it can be derived that in the 'full percolation' or direct EAP path structure of Fig. 3(b), the full voltage applied between electrodes 30, 31 may be directly applied, without losses, across the EAP particles 32 of each column. Hence, since in the illustrated example of Fig. 3(b), there are 10 EAP particles in each column, if for example, a 200V electric field is applied over the electrodes, the voltage supplied over each individual EAP particle is 20V.

By contrast, for the 'zero-percolation', or no direct EAP path, case of Fig. 3(a), the voltage supplied over each EAP particle is significantly less. This will now be illustrated with a quantitative example, presented below.

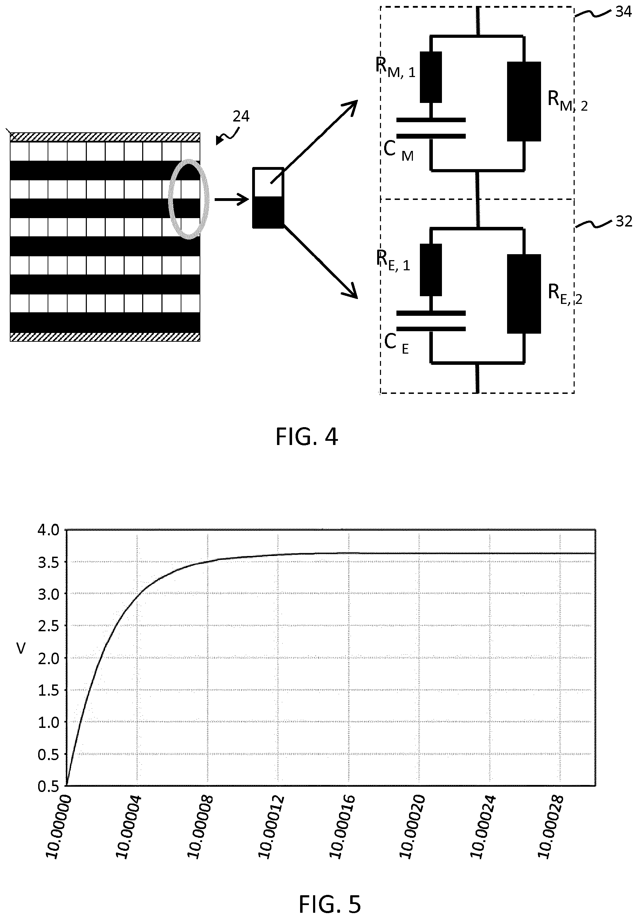

To illustrate, the structural arrangement of Fig. 3(a) is reproduced in Fig. 4, with an adjacent EAP 32 and matrix material 34 element each represented in terms of a respective notional RC circuit. Each RC circuit represents respective electrical properties of the material element in question.

For the EAP particle 32, the circuit is modeled as comprising a first resistor of resistance $R_{E,1}$ Ohms, a second resistor of resistance $R_{E,2}$ Ohms, and a capacitor of capacitance $C_E$ Farad.

This is taken to be connected in series with the circuit of the matrix material element 34. The matrix material element circuit is modelled as comprising a first resistor of resistance $R_{M,1}$ Ohms, a second resistor of resistance $R_{M,2}$ Ohms, and a capacitor of capacitance $C_M$ Farad.

For illustration, each material element 32, 34 is assumed to be approximately cubic in shape, with a diameter (or width) of 0.5 $\mu$m. A voltage of 40 V is taken to be applied over the combination of the two elements. This is based on the assumption used above that a total voltage of 200 V is applied over the entire chain of 10 elements, meaning 20 V applied over each single element, and hence a total of 40 V applied over the combination of the two elements 32, 34.

The matrix material element 34 may be taken to be comprised of thermoplastic polyurethane rubber, whilst the electroactive polymer particle may be taken to be comprised of Polyvinylidene fluoride-trifluoroethylene-chlorotrifluoroethylene.

For calculating the comparative electrical impedances of the two material elements 32, 34, the following ranges of typical values for the example materials used have been taken from literature.
$R_{M,2} \approx$ between $2 \times 10^{13}$ and $2 \times 10^{19}$ $\Omega$.
$C_M \approx$ between $1.7 \times 10^{-17}$ and $3 \times 10^{-17}$ F (assuming an ideal flat-plate capacitor) and
$R_{E,2} \approx$ between $2 \times 10^{15}$ and $2 \times 10^{16}$ $\Omega$
$C_E \approx$ between $4.4 \times 10^{-17}$ and $2.4 \times 10^{-16}$ F (assuming an ideal flat-plate capacitor).

In this case, the capacitance value of the matrix material element 34 may typically be around a factor of 1.5 to 14 times lower than that of the EAP particle 32, and the resistance value of the matrix element typically around a factor of 1000 to 10000 times higher than that of the EAP particle.

For this illustrative calculation, the following specific values are chosen, in order to calculate an exemplary voltage drop over the EAP particles:

$$R_{E,2} = 2 \times 10^{15} \ \Omega$$

$$C_E = 2.4 \times 10^{-16} \ F$$

and

$$R_{M,2} = 10 \times R_{E,2}$$

$$C_M \qquad = 1/10 \times C_E$$

The $R_{M,1}$ values are typically a factor of 20000 lower than the $R_{M,2}$ values and also the $R_{E,1}$ values are typically a factor of 2000 lower than the $R_{E,2}$ values. These values are also determined by the interface resistances between electrodes and the material in-between. Although in reality, only elements in contact with the electrodes have such interface resistances, for simplicity of calculation, these interface resistances are assumed to apply to all elements. The resultant estimated total resistance is hence above a true value.

By the use of a SPICE (Simulation Program with Integrated Circuit Emphasis) simulation (an open source electrical simulation package widely used in the art), the voltage over the EAP particle 32 as function of time can be simulated. The result is presented in Fig. 5.

Based upon the graph of Fig. 5, the time taken by the capacitor to charge to 63% may be determined. As the skilled person will be aware, this time is known as the 'RC time'.

The RC time in the present case is 25 μs. This is thus very fast compared with the typical speed at which human beings are capable of perceiving changes in physical states, and the typical operating time of an actuator. Thus, in the case of devices intended for human use comprising such actuator members, the actuation effect during charging of the capacitor is of little relevance, since the time taken is too short to be noticed or perceived.

Of more relevance is the voltage over the EAP particle 32 at times above approximately 100 ms. From the graph of Fig. 5, it can be readily seen that the voltage across the EAP particle after approximately 100 ms has reached a stable plateau value of approximately 3.6 V.

Hence, it can be seen that in the zero-percolation, or no direct EAP path, case of Fig. 3(a), with an assumed resistance as set out above of the matrix material elements 34 of just ten times greater than that of the EAP particles, a very substantial drop in voltage over the EAP particles has occurred: namely a drop from 20V (calculated above for the full EAP percolation case) to 3.6V for this case where penetration through matrix material is necessary.

As has been noted, in practical systems, the resistance of matrix material elements can in fact be up to 1000 times greater than that of the EAP particles. In these cases, it can immediately be seen that the voltage drop will be even more dramatic, reducing the applied voltage across EAP particles to close to zero.

It is clear then that the structural and material configuration of the actuator member has a highly significant effect upon the efficiency of power supply to the embedded EAP particles. Solutions are hence required to ensure reliable supply of electrical power to the elements under all circumstances.

As noted above, the present invention proposes two main (but linked) solution approaches to this. A first is based on providing continuous chains of, preferably fused, EAP particles extending through the composite material between the major surfaces, thereby providing effective electrical connection between all EAP particles. A second is based upon specially selecting or tuning electrical properties of the matrix material such as to be equal to or less than the electroactive polymer in terms of electrical resistivity.

The first solution approach will now be described.

In accordance with a first set of embodiments, there is provided an actuator member comprising one or more continuous material paths of electroactive polymer extending between a first and second major surface, each carrying a respective electrode for stimulating the actuator member, and wherein each path is formed from a continuous chain of electroactive polymer particles extending from the first major surface to the second major surface.

This set of embodiments is hence based upon controlled structuring of the actuator member such that a 'full EAP percolation' state, as illustrated schematically in Fig, 3(a) is achieved, wherein continuous paths of EAP particles extend from a first major surface 30 to a second 31.

A continuous EAP path structure similar to that depicted in Fig. 3(b) can be achieved in a number of different ways.

In accordance with a first set of embodiments, the structure may be achieved by forming the actuator member with a sufficiently high volume fraction of EAP compared to matrix material. In one set of embodiments in particular, the composite material may be formed or provided comprising at least 50% by volume of electroactive polymer particles, and preferably at least 70% by volume of electroactive polymer particles. When the actuator member is formed with 70% by volume of EAP particles in particular, it has been found that continuous paths of EAP tend reliably to form spontaneously during generation of the member, for instance during combining (e.g. mixing) of the matrix material and the EAP particles.

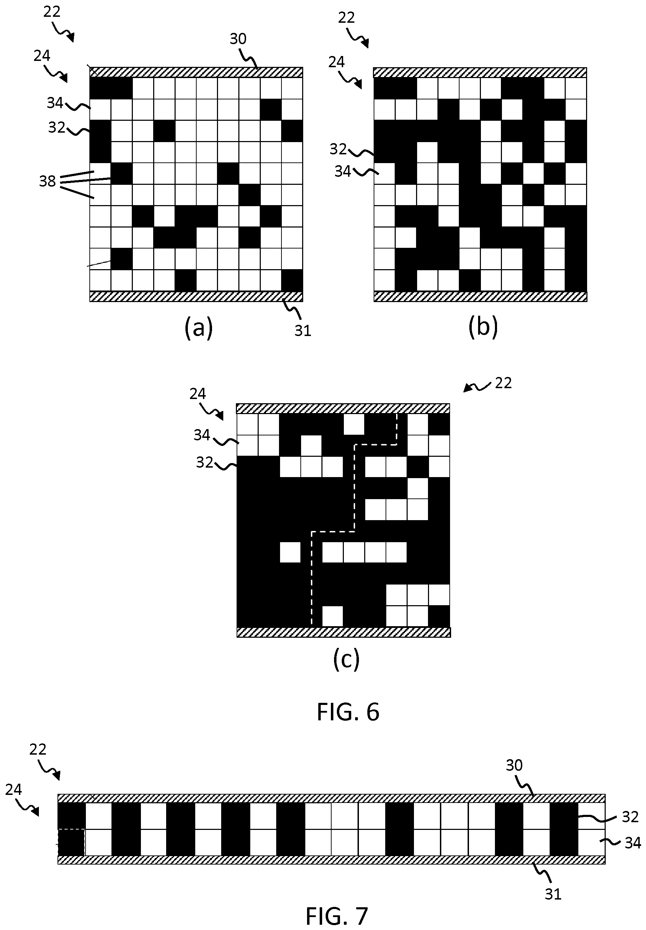

This will now be explained in detail with reference to Fig. 6.

Fig. 6 schematically depicts example actuator members 22 having bodies 24 formed of material composites comprised of each of three different example volume fractions of EAP particles. Figs. 6(a)-(c) schematically illustrate resulting structures following random mixing of EAP particles with compliant matrix material for each of the three different volume fractions.

Fig. 6(a) shows an actuator member body 24 comprising 20% by volume of EAP particles, Fig. 6(b) shows an actuator member body comprising 50% by volume EAP particles, and Fig. 6(c) shows an actuator member body comprising 70% by volume EAP particles. Each of the actuator members 22 comprises a first 30 and second 31 major surface, each provided with a respective electrode, the electrodes forming an electrode arrangement for electrically stimulating the EAP particles of the actuator member. The actuator member in combination with the electrode arrangement forms an actuator device in accordance with embodiments of the invention. The actuator device may further comprise a controller (not shown) for controlling provision of electrical stimuli to the actuator member body 24 for controlling actuation of the actuator member.

Although the illustrated structures of Figs. 6(a)-(c) are schematic only, it can readily be seen that clear differences in the resulting internal structural arrangements are observable.

At the 20% volume fraction of EAP particles shown in Fig. 6(a), no continuous paths of EAP material elements (i.e. no EAP percolation) can be observed between the first major surface 30 and the second major surface.

At the 50% volume fraction, illustrated in Fig. 6(b), there is significantly more interconnection between EAP particles within the composite material. In this state, there is a degree of at least weak connection formed between the first 30 and second 31 major surfaces. This is especially the case if annealing is performed, such that interconnection between elements only peripherally adjacent (for instance those only adjacent at the corners) is strengthened and secured, resulting in more robust connection between elements. With an annealing process, such fusing of EAP particles at their corners is highly likely to happen, in particular if the EAP material has intrinsically less attraction to the compliant matrix materials than with respect to itself.

It should be noted also that the schematic illustration of Fig. 6(b) is a two dimensional representation only. In a true three dimensional arrangement, a greater number of contact points between EAP particles would be observable.

At the 70% volume fraction shown in Fig. 6(c), it can be seen, even from the limited two-dimensional depiction presented, that at least one fully continuous path of EAP material is formed by the EAP particles 32 extending from the first major surface 30 to the second 31 (i.e. full EAP percolation is achieved). Naturally, in a full three-dimensional arrangement, a plurality of such direct paths would be formed. Hence, it can be seen that when including at least 70% by volume of EAP particles, the resulting actuator member tends reliably to form a plurality of robust continuous material paths of EAP particles extending between the major surfaces of the actuator member.

As noted above, the precise volume fraction of EAP particles required to reliably achieve spontaneous formation of continuous paths of EAP material can vary, in dependence upon a number of factors. It may depend in particular, upon the specific size and shape of the EAP particles used. It may depend also upon spontaneous (attractive) electrostatic interactions between elements. It can also be affected by any deliberately applied external electrical conditions when forming the actuator member body, for instance externally applied electrical fields, applied to induce attraction between EAP particles during fabrication. The depicted internal structures of Figs. 6(a)-(c) are merely schematic and illustrative, to demonstrate typical expected degrees of interconnection between EAP particles at different volume fractions (i.e. typical expected levels of EAP percolation at different volume fractions).

It is to be noted that the resulting internal material structure at for instance 70% volume fraction of EAP (Fig. 6(c)) is more complex than the simple ideal scenario of full percolation depicted in Fig. 3(b) for instance. In particular, the spontaneously formed paths of Fig. 6(c) are longer and more tortuous than those of the simple ideal scenario of Fig. 3(b). This naturally has an effect upon the achievable voltage across each of the EAP particles.

By way of example, one such EAP material path is indicated by a dashed white line in Fig 6(c). This path is longer than the ten elements which would comprise the shortest possible path between the electrodes 30, 31. Hence the voltage drop across each EAP particle in such a path will be lower than for those of the shortest possible path. For the shortest path, the voltage over one EAP particle is 20 V when 200 V is applied over the electrodes (as discussed above, in relation to Fig. 3(b)).

By contrast, for the illustrated path in Fig. 6(c) (indicated by the dashed white line), the path is formed of a chain of 14 EAP particles. In this case, the average voltage drop is 200/14 = 14.3 V.

Hence, for an actuator member body formed of a composite comprising 70% volume fraction of EAP particles, a voltage across each EAP particle in the chain may be approximately 70% of that of the ideal theoretical path. This is nonetheless a very good result, especially as compared with a zero EAP percolation case of for instance Fig. 3(a) in which a voltage of only 5.4 V was theoretically achievable, or significantly less where a resistance of the compliant matrix material is high. Hence, with respect to the zero-percolation configuration of Fig. 3(a) (roughly comparable with the 20% EAP volume fraction case of Fig. 6(a)), the random mixing case with 70% volume fraction EAP shows an improvement in the achievable voltage across EAP particles of (14.3 / 5.4) * 100% = 264 %.

As discussed above, resistance of the compliant matrix material can easily be a factor of 1000 greater than the electroactive polymer of the EAP particles 32. In such a case, if no continuous paths of EAP material are formed, voltage drop within the electrical system would be almost exclusively across the matrix material elements 34. The voltage drop over an EAP particle in this case would be virtually zero. Hence, the efficacy of the actuator would also in this case be almost zero.

Hence, it can be seen that providing sufficient volume fraction of EAP particles to matrix material, e.g. at least greater than 50%, e.g. preferably greater than 70% such that continuous chains of EAP particles are spontaneously formed between the major surfaces of the actuator member, electrical supply to the EAP particles of the actuator member body, and hence efficacy of the actuator may be significantly improved.

It is noted that although in the above presented electrical models, each EAP 32 and matrix material 34 element is assumed and depicted to be the same size, since the elements as modelled as so small (approximately 0.5 micrometers in width), any larger elements can always be described in terms of collections of multiple individual elements. Hence, any real-life arrangement can readily be understood through appropriate application of the model presented above.

To ensure robust electrical communication between the EAP particles forming each of the continuous material paths, the elements may in accordance with examples, be annealed subsequent to the formation and curing of the actuator member. In this way, the EAP particles are effectively fused to one another. It is thereby ensured that there is effective and robust contact between the EAP particles of each continuous material path, and also that the percolating EAP path will reliably remain as one body during deformation of the actuator member when stimulation of the EAP particles, and therefore actuation, is performed.

The EAP particles (for instance grains, granules, rods or any other particle) may be dispersed in the compliant matrix material layer. This may for instance be by mixing.

Alternatively, EAP particles may be pre-placed (e.g. poured) into a container in such a configuration that, upon adding of the matrix-forming liquid or resin, continuous interconnections between them are obtained automatically. After adding of the matrix forming liquid or resin, this liquid or resin is cured to form the actuator member body.

The matrix material may be a two component curing silicone or polyurethane having a very low viscosity after mixing.

Optionally, filling of the container with the matrix forming resin may be performed in an evacuated chamber, to prevent air entrapment.

Optionally, the EAP particle (e.g. granule, grain, rod, or other particle) bed may be (lightly) compressed to enhance interconnection between the elements in advance of adding the matrix-forming resin.

By way of a further alternative, the matrix forming resin may be mixed around a loose bundle of EAP fibers (or wires) and, after curing the matrix, slices then cut into the matrix, perpendicular to the fibers, to form the EAP particles. This still maintains the benefit of using EAP particles, as opposed to continuous layers of EAP (i.e. allowing for more localized control over shape or surface profile of the actuator member) whilst also helping to ensure that continuous paths of EAP material are provided, such that efficient electrical supply to the EAP particles is ensured.

By way of further alternative, elongate EAP particles may be mixed into a compliant thermoplastic or thermo-setting matrix. In an injection molding or extrusion process, the elongate particles will automatically align in the flow direction of the matrix. After cutting samples from the molded or extruded part, perpendicular to the flow direction, a strongly percolating structure of EAP particles can be obtained.

The compliant matrix material of the actuator member preferably has a thermosetting temperature which is lower than a melting temperature of the electroactive polymer. After setting of the compliant matrix, the temperature may then be further raised close to or just above the EAP melting point, causing the EAP particles to melt and fuse, causing formation of a continuous EAP phase within the compliant matrix material.

Where the matrix material has a thermosetting temperature which is lower than the melting temperature of the electroactive polymer, annealing of the EAP particles may be achieved at temperatures at or above the (onset of the) melting point of the EAP. This would not be possible in the case of an actuator member which is entirely formed of EAP, since the whole member structure would melt upon thus raising the temperature and lose its form.

By formation of an annealed and fused continuous path of EAP material, space charge build up, which can lead to premature breakdown of the material, is substantially suppressed, due to the continuous nature of the EAP phase.

Furthermore, during initial fabrication of the actuator member (which is formed of the composite material), the EAP material may be handled at a lower temperature than in the case that the entire actuator member were to be formed of EAP, where melt-processing of the EAP would be required. This also avoids other known difficulties with melt-processing of fluoropolymers in particular, such as corrosion of the melt processing equipment by the fluor containing EAP.

Increase in the degree of EAP material percolation, for instance where low EAP content is to be used, can be achieved through mechanical (shear flow) or electrical (dielectrophoresis) structuring or manipulation of the EAP particles inside the matrix material before setting of the matrix material.

Above has been described one way of achieving formation of continuous paths of EAP material extending from a first major surface of the actuator member to a second major surface, based upon including sufficient volume fraction of EAP particles to matrix material, and mixing or otherwise combining the particles with the matrix material.

Continuous paths of EAP particles extending from a first major surface to a second may be formed through deliberate controlled structuring of the body of the actuator member. The necessary structure may be formed through alternately printing EAP material and compliant matrix material, such as to effectively build up a layer structure of EAP material paths separated by interposing matrix material.

The resulting actuator member 22 is schematically depicted in Fig. 7. The actuator member body 24 is formed by alternately printing the EAP particles 32 and compliant matrix material 34 onto the bottom electrode 31 (as seen from the perspective of Fig. 7). This accordingly builds up, layer by layer, a regular structure of interposed pieces or elements of EAP material and matrix material. The resulting structure comprises a plurality of columns of EAP material, formed of chains of vertically stacked EAP particles. Where less EAP is desired, the surface area of the compliant matrix material particles within each layer of the layer structure may be made larger. After printing the layered EAP-matrix material actuator member body 24, this layer structure is provided with a top electrode 31.

In Fig. 7, two layers can be identified within the layer structure of the actuator member body. However, in other examples, just one layer may be provided or a layer structure of more than two layers may be provided. Again, although the EAP and matrix material elements are depicted as cubic in Fig. 7, this is by way of schematic illustration only, and in practical systems, may in fact be any of a range of shapes, such as, but not limited to cuboidal, cylindrical, round, or any other regular or irregular shape.

Again, optionally, the EAP particles may be annealed subsequent to printing to fuse the elements and generate robust electrical contact between EAP particles of each of the paths, and to ensure that each path remains robustly in a single piece despite repeated deformation of the actuator member during actuation.

Alternatively, a film may be extruded using two screws alternately ejecting compliant material and EAP material. By programming the revolutions of the extruder screws the resultant film may contain intermittent layers of elements of compliant and EAP material. Subsequently, this film may be laminated with opposing electrode layers, resulting in a structure substantially similar to that depicted in Fig. 7. Also multilayers can be laminated if desired.

In accordance with any embodiment of the invention, the compliant matrix material may, by way of example, be a rubber. In particular examples, a silicon rubber may be used having a maximum operating temperature of around 250 °C. The annealing procedure works most effectively when the annealing temperature of the EAP particles is lower than the maximum operating temperature of the matrix material. This allows annealing to be performed after fabrication of the actuator member, without damaging the matrix material. The annealing temperature of EAP particles will not exceed their melting temperature, which is typically in the order of 130-180 °C for many EAPs. Melting temperatures of a range of suitable EAP materials for use as EAP particles in embodiments of the present invention are shown in Table 1 below. Shown in Table 2 below are maximum operating temperatures for a range of different rubbers suitable for use as compliant matrix materials in embodiments of the present invention.

Hence it can be seen that EAP particles may be provided which can be annealed at a temperature comfortably below the maximum operating temperature of a range of different possible matrix materials.

Table 1

| Polymer Abbreviation | Polymer | Relative Permittivity | Melting Point (°C) | Resistivity ($\Omega$m) |
|---|---|---|---|---|
| PVDF | Poly(vinylidene fluoride) | 12 | 177 | $1 \times 10^{12}$ |
| PVDF-TrFE-CTFE | Polyvinylidene fluoride-trifluoroethylene-chlorotrifluoroethylene | 25-50 | 130 | $1 \times 10^{9}$ |
| PVDF-HFP | Poly(vinylidene fluoride-hexafluoropropylene) | 11 | 145 | $1 \times 10^{10}$ |

Table 2

| Matrix Material | Maximum Processing Temperature (°C) |
|---|---|
| Silicone rubber | 250 |
| Polyacrylate rubber | 175 |
| Ethylene Acrylic rubber | 175 |
| Ethylene propylene diene rubber | 200 |

When the annealing is carried out close to the melting temperature of the EAP, it may be necessary to carry out a post annealing temperature treatment procedure to ensure optimal performance of the EAP structure. The post annealing temperature treatment is typically a longer temperature treatment at temperatures lower than the melting temperature of the EAP. The treatment may typically last between 4-24 hours, at 10-15°C below the melting temperature of the EAP.

It is preferred to carry out an annealing step at the onset of the melting temperature, for instance at 105 °C. In addition, the composite may be applied with a slight pressure in the direction of the desired percolation of EAP material (i.e. in a direction normal to each of the electrodes or major surfaces of the actuator member) during the annealing procedure to ensure effective contact between the EAP particles such that efficient fusing between them can occur.

One example electroactive polymer which may be used for EAP particles in embodiments, is (66/34/8.3) P(VDF-TrFE-CTFE) terpolymer which has a relative permittivity in the order of 30 at a temperature of 20 °C. In Table 1 (above), other suitable EAP materials are also mentioned, as well as their relative permittivities, which vary for the different materials between 11 to 50.

In accordance with any embodiments of the present invention, a diverse range of materials may be used for the compliant matrix material. Preferably, this material may be a thermoset material, but also compliant thermoplastics may be used, provided that the material has a higher maximum operating temperature than the melting point of the EAP. An exemplary set of suitable matrix materials are listed above in Table 2. The relative dielectric constants of these compliant materials are in general relatively low, in the order of 2 to 4.

In general, in a composite material comprising a mixture of two or more different materials for instance, the required relative volume fraction of EAP compared to matrix material at which full EAP percolation will occur (i.e. spontaneous formation of continuous material paths between major surfaces) may vary.

In Materials Science and Engineering A328 (2002) 67-79, "Relations between microstructure, electrical percolation and corrosion in metal-insulator composites", E. Thommerel, J.C. Valmalette, J. Musso, S. Villain, J.R. Gavarri, is described a two component mixture in which full EAM percolation occurs when the volume fraction of EAM particles is in the order of 50%. In this publication, the electrical conductivity increases dramatically at this volume fraction, being an indication that full percolation has been achieved.

Above have been described embodiments in accordance with a first main solution approach of the invention, based on providing continuous paths of EAP material extending between major surfaces of the actuator member. In accordance with a second main solution approach, continuous material paths are provided formed of both EAP and matrix material, but where in the connecting matrix material has an electrical resistivity equal to or less than that of the EAP material within the path. In this way, efficient electrical supply to the EAP particles is provided.

This can be achieved in accordance with at least one set of embodiments by providing a matrix material which has uniformly equal or lower resistance than the EAP material of the EAP particles, and optionally equal or greater relative permittivity than the EAP material.

Here, continuous paths formed exclusively of EAP material are not necessary. Paths comprising both EAP particles and matrix material may be utilized, due to the similarity of electrical properties of the two materials.

Hence, embodiments in accordance with this second approach are based upon providing a compliant matrix material having an electrical resistivity which is substantially equal to or is lower than that of the EAP material elements, or a relative permittivity which is equal to or greater than that of the EAP material elements, whilst still maintaining a difference in stiffness of the compliant material and the EAP. In this manner, voltage drop over the EAP particles and compliant material elements will be similar, thus avoiding dominance of the matrix material within the electrical system, and ensuring effective electrical supply to the EAP particles.

Requiring this relationship between the material properties will naturally limit the choice as to the matrix material and the electroactive polymer.

In the case of low operating voltages (in the order for instance of 50-250 V), disparity in the relative permittivities of the two materials may be tolerated, since even in high field strength regions, operation would remain below the electrical breakdown voltage. However, by ensuring resistivity of the matrix is equal to or lower than that of the EAP, good electrical supply to the EAP is ensured and hence effective operation of the actuator can be maintained.

Achieving this relation in electrical properties between the matrix material and the EAP particles may be realized either by using matrix materials having intrinsically similar or lower resistivity, or by adding suitable filler materials to the matrix, having electrical properties which in combination with those of the matrix material achieve the equal or lower relative resistivity of the matrix. Suitable fillers for reducing the resistivity of the matrix may e.g. include carbon particles.

Shown in Table 3 below is a range of suitable matrix materials for the actuator member, spanning a range of different electrical resistivities.

**Table 3**

| Matrix Material | Resistivity [$\Omega$m] |
| --- | --- |
| Silicone rubber | $10 \times 10^{12}$ |
| Fluoroelastomer | $5 \times 10^{10}$ |
| acrylonitrile-butadiene rubber | $10 \times 10^{8}$ |
| Ethylene propylene diene rubber | $1 \times 10^{12}$ |
| Chloroprene rubber | $10 \times 10^{10}$ |

This list represents just one (limited) example set of materials and their electrical properties. It can be seen however that for any given EAP material, it is highly likely that a suitable matrix material can be found having resistivity which is equal to or lower than that of the EAP material. The resistivities for a sample set of EAP materials are listed above in Table 1. The skilled person however will naturally understand that other EAP or EAP materials, as outlined in more detail below for instance, may also be used, and their resistivities readily discovered, either from standard literature sources, or by testing a sample of material to determine its resistivity.

Determining the resistivity of a sample of material may be easily performed by e.g. applying an electrical signal across the material of known current and voltage to thereby determine a resistance of the material using Ohm's law. The standard expression $\rho = R \cdot A / L$ may then be used to determine the resistivity, where $\rho$ is resistivity of the material, R is the measured resistance across is, A is the cross-sectional area of the sample, and L is a length of the sample extending perpendicularly to the surface area.

As noted above, fillers may be added to the matrix material to tune its electrical resistivity so as to be equal to or less than that of the EAP particles. These may be conducting particles, such as carbon particles.

It may be considered to provide a matrix material having a relative permittivity which is larger than that of the EAP material elements. This would mean that, as voltage or current is first supplied to the actuator member, and charge first begins to build across the matrix and EAP material elements by virtue of their respective intrinsic capacitances, the voltage drop across the EAP particles (i.e. the voltage supply across the EAP particles) would be higher than over the matrix material elements.

However, this may not be a preferred option, since (as discussed above) the characteristic relaxation time (RC time) for the matrix and EAP particles in embodiments of the present invention is very short (in the order of << 1 ms). This means that in practical terms, the voltage division over the EAP and matrix material elements respectively is mostly determined (i.e. for all times after said initial << 1 ms) by the ratio of resistances of the material elements. Furthermore, any disparity in relative permittivities leads to inhomogeneity in electrical field strength over the actuator member, which can lead to electrical breakdown at lower voltages.

As discussed in sections above, typical capacitive charging times for material elements of the actuator members of the present invention are much shorter than the typical operating time of the actuator members, and hence in practical terms, the voltage division or distribution across material elements may be assumed to be determined almost exclusively by the relative resistances of the matrix material and the electroactive polymer of the EAP particles.

Hence, in accordance with one or more embodiments, the matrix material may be provided having a resistivity which is lower than that of the EAP particles. This will thus result in an increase in the relative voltage supplied across the EAP particles compared with the matrix material.

Since electrical resistances across EAP and matrix material elements are generally relatively high, this reduction in the resistivity of the matrix material, may be achieved without consequently causing significant increases in joule heating and other undesirable temperature increases of the actuator.

Hence, by selecting appropriate EAP and matrix materials, such that a resistivity of the matrix material is lower than that of the EAP particles, relative electrical supply to the EAP particles may be boosted, even where differences exist in the respective relative permittivities of the matrix material and the electro-active material.

The use of matrix material having equal or lower resistivity than the electroactive polymer may be combined with the approach outlined above in which EAP particles are randomly combined with the matrix material in sufficiently high volume fraction to ensure spontaneous formation of continuous material paths. This ensures that even in those cases where sufficient numbers of continuous material paths are not formed, efficient electrical supply to the EAP particles is nonetheless provided. Even where sufficient numbers of material paths are formed, the use of in addition matrix material having equal or lower resistivity than the EAP may further enhance or support effectiveness of electrical supply to the EAP particles.

Embodiments of the present invention may be used in a wide range of different applications. Embodiments provide actuator members having EAP particles embedded in a compliant matrix material which, as discussed above, enables highly controlled deformation of the shape or surface profile of the actuator member. Embodiments of the present invention are useful not only in providing standard actuation stroke, but also in controlling directionality of the stroke (e.g. tilting), and shape change of the actuator member

In a number of applications, controlling of the surface shape of the actuator member or a body to which it is coupled is useful, for instance in facilitating effective contact between interfacing surfaces, e.g. on-body sensing/imaging systems. In other applications, local surface change can be used to provide additional functionality, such as e.g. friction control, massage, cleaning or microfluidics manipulation. In either case, flexibility in surface change is desired, and implementation of proposed solutions of the present invention can provide this. Also use in transporting information is foreseen.

Specific application areas in which embodiments of the present invention may usefully be applied include, but are not limited to: ultrasound imaging (e.g. large area ultrasound scanning, mechanical focusing, wearable devices), tonometry, oral healthcare devices (e.g. toothbrushes), shaving (e.g. manipulating a surface shape or directionality of a shaver contact surface), and microfluidics.

A controllable surface shape change may be implemented by providing an arrangement of one or more electrode pairs, each sandwiching at least a portion the actuator member. By suitably controlling these one or more electrode pairs to generate respective fields across their at least portion of the actuator member, these portions can be independently stimulated to deform. This may therefore provide controllable deformation of a surface profile of the actuator member, and in particular enables implementation of a non-uniform, i.e. contoured, surface deformation. This enables improved shaping of a surface of the actuator member for instance to enable better surface contact or interfacing between the actuator member surface and an incident surface to which it is applied, e.g. a tissue or skin surface. Where a plurality of electrode pairs is provided, these may be controlled independently to thereby enable application of electric fields of different field strengths across different portions of the actuator member to thereby facilitate controllable non-uniform (i.e. contoured) surface profile deformation.

Materials suitable for electroactive polymer of the actuator member are known. Electro-active polymers include, but are not limited to, the sub-classes: piezoelectric polymers, electromechanical polymers, relaxor ferroelectric polymers, electrostrictive polymers, dielectric elastomers, liquid crystal elastomers, conjugated polymers, Ionic Polymer Metal Composites, ionic gels and polymer gels.

The sub-class electrostrictive polymers includes, but is not limited to:
Polyvinylidene fluoride (PVDF), Polyvinylidene fluoride - trifluoroethylene (PVDF-TrFE), Polyvinylidene fluoride - trifluoroethylene - chlorofluoroethylene (PVDF-TrFE-CFE), Polyvinylidene fluoride - trifluoroethylene - chlorotrifluoroethylene) (PVDF-TrFE-CTFE), Polyvinylidene fluoride- hexafluoropropylene (PVDF - HFP), polyurethanes or blends thereof.

The sub-class dielectric elastomers includes, but is not limited to: acrylates, polyurethanes, silicones.

The sub-class conjugated polymers includes, but is not limited to: polypyrrole, poly-3, 4-ethylenedioxythiophene, poly(p-phenylene sulfide), polyanilines.

In all of these examples, additional passive layers may be provided for influencing the electrical and/or mechanical behavior of the EAP particle in response to an applied electric field.

Each EAP particle may be sandwiched between electrodes. The electrodes may be stretchable so that they follow the deformation of the EAP material. Materials suitable for the electrodes should be ultrasound-transmissive and include for instance thin metal films, such as gold, copper, or aluminum or organic conductors such as carbon black, carbon nanotubes, graphene, poly-aniline (PANI), poly(3,4-ethylenedioxythiophene) (PEDOT), e.g. poly(3,4-ethylenedioxythiophene) poly(styrenesulfonate) (PEDOT:PSS).

If the electrodes are arranged in a non-symmetric configuration, the imposed voltage can induce all kinds of deformations such as twisting, rolling, torsioning, turning, and non-symmetric bending deformation.

Further EAP materials that may be used for EAP particles in accordance with embodiments of the present invention include but are not limited to:

- polyvinylidene fluoride-tetrafluoroethylene;
- polyvinylidene fluoride-tetrafluoroethylene-chlorotrifluoroethylene;
- polyvinylidene fluoride-trifluoroethylene-hexafluoropropylene;
- polyvinylidene fluoride-tetrafluoroethylene-hexafluoropropylene;
- polyvinylidene fluoride-trifluoroethylene-tetrafluoroethylene;
- polyvinylidene fluoride-tetrafluoroethylene-tetrafluoroethylene;
- polyvinylidene fluoride-trifluoroethylene-vinyl fluoride;
- polyvinylidene fluoride-tetrafluoroethylene-vinyl fluoride;
- polyvinylidene fluoride-trifluoroethylene-perfluoro(methyl vinyl ether);
- polyvinylidene fluoride-tetrafluoroethylene-perfluoro(methyl vinyl ether);
- polyvinylidene fluoride-trifluoroethylene-bromotrifluoroethylene;
- polyvinylidene fluoride-tetrafluoroethylene-bromotrifluoroethylene;
- polyvinylidene fluoride-tetrafluoroethylene-chlorofluoroethylene;
- polyvinylidene fluoride-trifluoroethylene-vinylidene chloride; and
- polyvinylidene fluoride-tetrafluoroethylene-vinylidene chloride.

As discussed above, some embodiments of the actuator device aspect of the present invention make use of a controller. The controller can be implemented in numerous ways, with software and/or hardware, to perform the various functions required. A processor is one example of a controller which employs one or more microprocessors that may be programmed using software (e.g., microcode) to perform the required functions. A controller may however be implemented with or without employing a processor, and also may be implemented as a combination of dedicated hardware to perform some functions and a processor (e.g., one or more programmed microprocessors and associated circuitry) to perform other functions.

Examples of controller components that may be employed in various embodiments of the present disclosure include, but are not limited to, conventional microprocessors, application specific integrated circuits (ASICs), and field-programmable gate arrays (FPGAs).

In various implementations, a processor or controller may be associated with one or more storage media such as volatile and non-volatile computer memory such as RAM, PROM, EPROM, and EEPROM. The storage media may be encoded with one or more programs that, when executed on one or more processors and/or controllers, perform the required functions. Various storage media may be fixed within a processor or controller or may be transportable, such that the one or more programs stored thereon can be loaded into a processor or controller.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1.  An actuator member (22) comprising a body (24) of composite material having a first major surface (30) and a second major surface (31), the composite material comprising electroactive polymer particles (32) distributed in a compliant matrix material (34), and wherein the composite material of the body comprises one or more continuous material paths extending from the first major surface to the second major surface, each encompassing at least one electroactive polymer particle, and wherein all material forming each of the paths has an electrical resistivity equal to or less than an electrical resistivity of the electroactive polymer particles.

2.  An actuator member (22) as claimed in claim 1, wherein the composite material (34) of said body (24) comprises a plurality of said continuous material paths.

3.  An actuator member (22) as claimed in any of claims 1 to 2, wherein all material forming each of said continuous material paths further has a relative permittivity equal to or greater than a relative permittivity of the electroactive polymer particles.

4.  An actuator member (22) as claimed in any preceding claim, wherein one or more of the material paths is a continuous path of electroactive polymer, formed by a continuous chain of electroactive polymer particles (32) extending from the first major surface (30) to the second major surface (31).

5.  An actuator member (22) as claimed in any preceding claim, wherein one or more of the material paths is a composite path formed of at least one electroactive polymer particle (32) and connecting matrix material, said connecting matrix material having an electrical resistivity equal to or less than the electrical resistivity of the electroactive polymer particles, and preferably wherein said connecting matrix material has an electrical resistivity less than that of the electroactive polymer particles.

6.  An actuator member (22) as claimed in any preceding claim, wherein the composite material comprises at least 25% by volume of electroactive polymer particles (32), and preferably comprises at least 50% by volume of electroactive polymer particles, and more preferably comprises at least 70% by volume of electroactive polymer particles.

7.  An actuator member (22) as claimed in any preceding claim wherein the compliant matrix material (34) has an electrical resistivity equal to or less than that of the electroactive polymer particles (32), and preferably wherein the compliant matrix material has an electrical resistivity less than that of the electroactive polymer particles.

8.  An actuator member (22) as claimed in claim 7, wherein the compliant matrix material (34) comprises conductive particles for reducing an electrical resistivity of the matrix material.

9.  An actuator device comprising:

    an actuator member (22) as claimed in any preceding claim; and
    an electrode arrangement disposed about said first (30) and second (31) major surfaces for electrically stimulating the actuator member.

10. A method of forming an actuator member (22) comprising:

surrounding a plurality of electroactive polymer particles (32) with a compliant matrix material (34) such as to form a composite material body (24) having a first (30) and second (31) major surface, the body being such as to define one or more continuous material paths extending from the first major surface to the second major surface, each encompassing at least one electroactive polymer particle (32), and wherein all material forming each of the paths has an electrical resistivity equal to or less than an electrical resistivity of the electroactive polymer particles; and
curing the matrix material to thereby form the actuator member.

11. A method as claimed in claim 10, further comprising heating the composite material body (24) after curing of the matrix material (34) to anneal the electroactive polymer particles (32).

12. A method as claimed in claim 10 or 11, wherein said surrounding comprises dispersing electroactive polymer particles (32) within a compliant matrix material (34).

13. A method as claimed in claim 10 or 11, wherein said surrounding comprises alternately printing portions of electroactive polymer (32) and compliant matrix material (34) onto a substrate, and optionally wherein said substrate is an electrode (31) for electrically stimulating the actuator member (22).

14. A method as claimed in any of claims 10 to 13, wherein said body (24) is formed with at least 25% by volume of electroactive polymer particles (32), and preferably at least 50% by volume of electroactive polymer particles (32), and more preferably at least 70% by volume of electroactive polymer particles (32).

**Patentansprüche**

1. Eine Aktorkomponente (22) mit einem Gehäuse (24) aus Verbundmaterial mit einer ersten Hauptoberfläche (30) und einer zweiten Hauptoberfläche (31), wobei das Verbundmaterial elektroaktive Polymerteilchen (32) umfasst, die in einem passenden Matrixmaterial (34) verteilt sind, und wobei das Verbundmaterial des Gehäuses mindestens eine durchgehende Materialbahn umfasst, die sich von der ersten Hauptoberfläche zur zweiten Hauptoberfläche erstreckt und jeweils mindestens ein elektroaktives Polymerteilchen umfasst, und wobei alle Materialien, die die einzelnen Bahnen bilden, einen spezifischen elektrischen Widerstand aufweisen, der höchstens dem spezifischen elektrischen Widerstand der elektroaktiven Polymerteilchen entspricht.

2. Eine Aktorkomponente (22) gemäß Anspruch 1, wobei das Verbundmaterial (34) des Gehäuses (24) mehrere durchgehende Materialbahnen umfasst.

3. Die Aktorkomponente (22) gemäß einem der Ansprüche 1 bis 2, wobei alle Materialien, die die einzelnen durchgehenden Materialbahnen bilden, zudem eine relative Dielektrizitätskonstante aufweisen, die mindestens der relativen Dielektrizitätskonstante der elektroaktiven Polymerteilchen entspricht.

4. Eine Aktorkomponente (22) gemäß einem der vorhergehenden Ansprüche, wobei es sich bei mindestens einer der Materialbahnen um eine durchgehende Bahn aus elektroaktivem Polymer handelt, die durch eine fortlaufende Kette von elektroaktiven Polymerteilchen (32) gebildet wird, die sich von der ersten Hauptoberfläche (30) zur zweiten Hauptoberfläche (31) erstreckt.

5. Eine Aktorkomponente (22) gemäß einem der vorhergehenden Ansprüche, wobei es sich bei mindestens einer der Materialbahnen um eine Verbundbahn handelt, sie aus mindestens einem elektroaktiven Polymerteilchen (32) und einem Verbindungsmatrixmaterial gebildet wird, wobei das Verbindungsmatrixmaterial einen spezifischen elektrischen Widerstand aufweist, der höchstens dem spezifischen elektrischen Widerstand der elektroaktiven Polymerteilchen entspricht, und wobei das Verbindungsmatrixmaterial vorzugsweise einen spezifischen elektrischen Widerstand aufweist, der kleiner ist als der der elektroaktiven Polymerteilchen.

6. Eine Aktorkomponente (22) gemäß einem der vorhergehenden Ansprüche, wobei das Verbundmaterial mindestens 25 Vol.-% elektroaktive Polymerteilchen (32), vorzugsweise mindestens 50 Vol.-% elektroaktive Polymerteilchen und im Idealfall mindestens 70 Vol.-% elektroaktive Polymerteilchen umfasst.

**7.** Eine Aktorkomponente (22) gemäß einem der vorhergehenden Ansprüche, wobei das konforme Matrixmaterial (34) einen spezifischen elektrischen Widerstand aufweist, der höchstens dem der elektroaktiven Polymerteilchen (32) entspricht, und wobei das konforme Matrixmaterial vorzugsweise einen spezifischen elektrischen Widerstand aufweist, der kleiner ist als der der elektroaktiven Polymerteilchen.

**8.** Eine Aktorkomponente (22) gemäß Anspruch 7, wobei das konforme Matrixmaterial (34) leitfähige Teilchen zur Verringerung des spezifischen elektrischen Widerstands des Matrixmaterials umfasst.

**9.** Ein Aktor, der Folgendes umfasst:

eine Aktorkomponente (22) gemäß einem der vorhergehenden Ansprüche; und
eine Elektrodenanordnung, die um die erste (30) und zweite (31) Hauptfläche herum angeordnet ist, um die Aktorkomponente elektrisch zu stimulieren.

**10.** Eine Methode zum Bilden einer Aktorkomponente (22), die folgende Schritte umfasst:

Umgeben mehrerer elektroaktiver Polymerteilchen (32) mit einem konformen Matrixmaterial (34), um ein Gehäuse (24) aus Verbundmaterial mit einer ersten (30) und einer zweiten (31) Hauptoberfläche zu bilden, wobei das Gehäuse mindestens eine durchgehende Materialbahn definiert, die sich von der ersten Hauptoberfläche zur zweiten Hauptoberfläche erstreckt und jeweils mindestens ein elektroaktives Polymerteilchen (32) umfasst, und wobei alle Materialien, die die einzelnen Bahnen bilden, einen spezifischen elektrischen Widerstand aufweisen, der höchstens dem spezifischen elektrischen Widerstand der elektroaktiven Polymerteilchen entspricht; und
Aushärten des Matrixmaterials, um die Aktorkomponente zu bilden.

**11.** Eine Methode gemäß Anspruch 10, die zudem das Erhitzen des Gehäuses (24) aus Verbundmaterial im Anschluss an das Aushärten des Matrixmaterials (34) umfasst, um die elektroaktiven Polymerteilchen (32) auszuhärten.

**12.** Eine Methode gemäß Anspruch 10 oder 11, wobei das Umgeben das Verteilen von elektroaktiven Polymerteilchen (32) in einem konformen Matrixmaterial (34) umfasst.

**13.** Eine Methode gemäß Anspruch 10 oder 11, wobei das Umgeben das abwechselnde Pressen von Teilen des elektroaktiven Polymers (32) und des konformen Matrixmaterials (34) auf ein Substrat umfasst, und wobei es sich beim Substrat optional um eine Elektrode (31) für das elektrische Stimulieren der Aktorkomponente (22) handelt.

**14.** Die Methode gemäß einem der Ansprüche 10 bis 13, wobei das Gehäuse (24) mindestens 25 Vol.-% elektroaktive Polymerteilchen (32), vorzugsweise mindestens 50 Vol.-% elektroaktive Polymerteilchen (32) und im Idealfall mindestens 70 Vol.-% elektroaktive Polymerteilchen (32) umfasst.

## Revendications

**1.** Élément actionneur (22) comprenant un corps (24) en matière composite comportant une première surface principale (30) et une seconde surface principale (31), la matière composite comprenant des particules de polymère électroactif (32) réparties dans une matière de matrice (34) souple, et dans lequel la matière composite du corps comprend au moins un chemin continu de matière s'étendant de la première surface principale à la seconde surface principale, chacun englobant au moins une particule de polymère électroactif, et dans lequel toute la matière forme chacun des chemins à une résistivité électrique égale ou inférieure à une résistivité électrique des particules de polymère électroactif.

**2.** Élément actionneur (22) selon la revendication 1, dans lequel la matière composite (34) dudit corps (24) comprend une pluralité desdits chemins continus de matière.

**3.** Élément actionneur (22) selon l'une quelconque des revendications 1 à 2, dans lequel toute la matière formant chacun desdits chemins continus de matière présente en outre une permittivité relative égale ou supérieure à une permittivité relative des particules de polymère électroactif.

**4.** Élément actionneur (22) selon l'une quelconque des revendications précédentes, dans lequel l'au moins un des chemins de matière est un chemin continu de polymère électroactif, formé par une chaîne continue de particules de polymère électroactif (32) s'étendant de la première surface principale (30) à la seconde surface principale (31).

5. Élément actionneur (22) selon l'une quelconque des revendications précédentes, dans lequel l'au moins un des chemins de matière est un chemin composite formé de l'au moins une particule de polymère électroactif (32) et d'une matière de matrice de connexion, ladite matière de matrice de connexion présentant une résistivité électrique égale ou inférieure à la résistivité électrique des particules de polymère électroactif, et de préférence dans lequel ladite matière de matrice de connexion présente une résistivité électrique inférieure à celle des particules de polymère électroactif.

6. Élément actionneur (22) selon l'une quelconque des revendications précédentes, dans lequel la matière composite comprend au moins 25 % en volume de particules de polymère électroactif (32), et comprend de préférence au moins 50 % en volume de particules de polymère électroactif, et de préférence encore comprend au moins 70 % en volume de particules de polymère électroactif.

7. Élément actionneur (22) selon l'une quelconque des revendications précédentes, dans lequel la matière de matrice (34) souple présente une résistivité électrique égale ou inférieure à celle des particules de polymère électroactif (32), et de préférence dans lequel la matière de matrice souple présente une résistivité électrique inférieure à celle des particules de polymère électroactif.

8. Élément actionneur (22) selon la revendication 7, dans lequel la matière de matrice souple (34) comprend des particules conductrices destinées à la réduction d'une résistivité électrique de la matière de matrice.

9. Dispositif d'actionnement comprenant :

   un élément actionneur (22) selon l'une quelconque des revendications précédentes ; et
   un agencement d'électrodes disposées autour desdites première (30) et seconde (31) surfaces principales destinées à la stimulation électrique de l'élément actionneur.

10. Procédé de formation d'un élément actionneur (22) comprenant :

   l'entourage d'une pluralité de particules de polymère électroactif (32) par une matière de matrice (34) souple de manière à former un corps en matière composite (24) comportant une première (30) et une seconde (31) surface principale, le corps étant tel qu'il définit au moins un chemin continu de matière s'étendant de la première surface principale à la seconde surface principale, chacun englobant l'au moins une particule de polymère électroactif (32), et dans lequel toute la matière formant chacun des chemins présente une résistivité électrique égale ou inférieure à une résistivité électrique des particules de polymère électroactif ; et
   le durcissement de la matière de matrice pour former ainsi l'élément actionneur.

11. Procédé selon la revendication 10, comprenant en outre le chauffage du corps en matière composite (24) après le durcissement de la matière de matrice (34) pour recuire les particules de polymère électroactif (32) .

12. Procédé selon la revendication 10 ou 11, dans lequel ledit environnement comprend la dispersion de particules de polymère électroactif (32) à l'intérieur d'une matière de matrice (34) souple.

13. Procédé selon la revendication 10 ou 11, dans lequel ledit entourage comprend l'impression en alternance de parties de polymère électroactif (32) et de matière de matrice (34) souple sur un substrat, et éventuellement dans lequel ledit substrat est une électrode (31) destinée à la stimulation électrique de l'élément actionneur (22).

14. Procédé selon l'une quelconque des revendications 10 à 13, dans lequel ledit corps (24) est formé avec au moins 25 % en volume de particules de polymère électroactif (32), et de préférence au moins 50 % en volume de particules de polymère électroactif (32), et de préférence encore au moins 70 % en volume de particules de polymère électroactif (32).

FIG. 1

FIG. 2

(a)                                            (b)

FIG. 3

FIG. 4

FIG. 5

FIG. 6

FIG. 7

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2014004364 A

**Non-patent literature cited in the description**

- **E. THOMMEREL ; J.C. VALMALETTE ; J. MUSSO ; S. VILLAIN ; J.R. GAVARRI.** Relations between microstructure, electrical percolation and corrosion in metal-insulator composites. *Materials Science and Engineering,* 2002, vol. A328, 67-79